# EUROPÄISCHE PATENTSCHRIFT

(11) **EP 2 474 003 B1**
(45) Veröffentlichungstag und Bekanntmachung des Hinweises auf die Patenterteilung: **16.10.2013**
(21) Anmeldenummer: 10745252.6
(22) Anmeldetag: 25.08.2010
(51) Int. Cl.: H01B 1/16

(54) **ZUSAMMENSETZUNG ZUM DRUCKEN VON LEITERBAHNEN SOWIE EIN VERFAHREN ZUR HERSTELLUNG VON SOLARZELLEN**
COMPOSITION FOR THE PRINTING OF STRIP CONDUCTORS AND PROCESS FOR THE PRODUCTION OF SOLAR CELLS
COMPOSITION POUR IMPRIMER DES PISTES CONDUCTIVES ET UN PROCEDE POUR LA PRODUCTION DES CELLULES SOLAIRE

(30) Priorität: 04.09.2009 EP 09169549
(43) Veröffentlichungstag der Anmeldung: 11.07.2012
(73) Patentinhaber: BASF SE, 67056 Ludwigshafen (DE)
(72) Erfinder: KLEINE JÄGER, Frank, 67098 Bad Dürkheim (DE); HERMES, Stephan, 67098 Bad Dürkheim (DE)
(86) Internationale Anmeldenummer: PCT/EP2010/062404
(87) Internationale Veröffentlichungsnummer: WO 2011/026769

(56) Entgegenhaltungen:
- EP-A1- 1 887 106
- WO-A1-2007/089273
- WO-A2-2006/132766

## Beschreibung

Die Erfindung betrifft eine Zusammensetzung zum Drucken von Leiterbahnen auf ein Substrat, insbesondere für Solarzellen, unter Einsatz eines Laserdruckverfahrens, wobei die Zusammensetzung 30 bis 90 Gew.-% elektrisch leitfähige Partikel, 0 bis 7 Gew.-% Glasfritte, 0 bis 8 Gew.-% mindestens eines Matrixmaterials, 0 bis 8 Gew.-% mindestens einer metallorganischen Verbindung, 0 bis 5 Gew.-% mindestens eines Additivs und 3 bis 50 Gew.-% Lösungsmittel enthält. Die Erfindung betrifft weiterhin ein Verfahren zur Herstellung von Solarzellen, bei dem eine entsprechende Zusammensetzung auf ein Halbleitersubstrat aufgedruckt wird, indem die Zusammensetzung von einem Träger durch Einstrahlung mit einem Laser auf das Halbleitersubstrat übertragen wird.

Um die Zusammensetzung durch ein Laserdruckverfahren auf das Substrat aufdrucken zu können, muss die Zusammensetzung ein Absorptionsmittel für Laserstrahlung enthalten, welches die Energie der Laserstrahlung absorbiert und in Wärme umwandelt.

Absorptionsmittel, die derzeit in Tinten für Laserdruck eingesetzt werden, sind zum Beispiel Ruße oder Kohlenstoffnanoröhrchen. Diese haben jedoch den Nachteil, dass sie beim Brennen der Solarzellen zu Kohlendioxid reagieren, das gasförmig in den Leiterbahnen verbleibt, wodurch Poren in den Leiterbahnen entstehen, die die Leitfähigkeit absenken können. Um dies zu vermeiden, werden derzeit üblicherweise rußfreie Zusammensetzungen eingesetzt, die durch Tintenstrahldruckverfahren oder durch Siebdruckverfahren verarbeitet werden.

Eine Zusammensetzung in Pastenform, die zur Herstellung einer Licht empfangenden Oberflächenelektrode einer Solarzelle eingesetzt werden kann, ist zum Beispiel in WO 2007/089273 beschrieben. Die Paste enthält Silberpartikel mit einer spezifischen Oberfläche von 0,2 bis 0,6 m²/g, Glasfritte, Harzbindemittel und Verdünnungsmittel.

Eine Zusammensetzung, die Silberpulver mit zwei unterschiedlichen mittleren Durchmessern enthält, ist in EP-A 1 775 759 beschrieben. Neben dem Silberpulver enthält die Zusammensetzung ebenfalls Glasfritte und einen organischen Träger. Der Anteil an Silber im Elektrodenmaterial beträgt 75 bis 95 Gew.-%.

Eine weitere Paste zur Herstellung von Elektroden für Solarzellen, die 85 bis 99 Gew.-% einer leitfähigen Metallkomponente und 1 bis 15 Gew.-% einer Glaskomponente jeweils bezogen auf die Feststoffmasse sowie einen organischen Anteil enthält, ist in WO 2006/132766 beschrieben.

Die jeweils beschriebenen Zusammensetzungen können nicht zum Verdrucken durch Laserdruck verwendet werden. Der Einsatz eines Laserdruckverfahrens hat jedoch gegenüber Tintenstrahldruckverfahren und Siebdruckverfahren den Vorteil, dass feinere Linien und damit feinere Elektroden auf die Solarzelle gedruckt werden können.

Aufgabe der vorliegenden Erfindung ist es, eine Zusammensetzung zum Drucken von Elektroden für Solarzellen bereitzustellen, die durch Laserdruck verdruckbar ist, und bei der im Vergleich zu bekannten Zusammensetzungen keine Verringerung der Leitfähigkeit durch das Brennen erfolgt.

Gelöst wird die Aufgabe durch eine Zusammensetzung zum Drucken von Leiterbahnen auf ein Substrat, insbesondere für Solarzellen, unter Einsatz eines Laserdruckverfahrens, wobei die Zusammensetzung 30 bis 90 Gew.-% elektrisch leitfähige Partikel, 0 bis 7 Gew.-% Glasfritte, 0 bis 8 Gew.-% mindestens eines Matrixmaterials, 0 bis 8 Gew.-% mindestens einer metallorganischen Verbindung, 0 bis 5 Gew.-% mindestens eines Additivs und 3 bis 69 Gew.-% Lösungsmittel enthält, wobei die Zusammensetzung weiterhin 0,5 bis 15 Gew.-% Nanopartikel als Absorptionsmittel für Laserstrahlung enthält, wobei die Nanopartikel Partikel aus Silber, Gold, Platin, Palladium, Wolfram, Nickel, Zinn, Bismut, Eisen, Indiumzinnoxid (ITO), Wolframoxid, Titancarbid oder Titannitrid sind und die Zusammensetzung maximal 1 Gew.-% elementaren Kohlenstoff enthält.

Als Nanopartikel im Sinne der vorliegenden Erfindung sind Partikel mit einer Partikelgröße im Bereich von 1 bis 800 nm zu verstehen. Als Absorptionsmittel eingesetzte Nanopartikel weisen üblicherweise eine Partikelgröße im Bereich von 3 bis 800 nm auf.

Der Anteil an elementarem Kohlenstoff in der Zusammensetzung beträgt maximal 1 Gew.-%, bevorzugt maximal 0,5 Gew.-%, mehr bevorzugt maximal 0,3 Gew.-% und insbesondere maximal 0,1 Gew.-%. In einer Ausführungsform ist kein elementarer Kohlenstoff in der Zusammensetzung enthalten.

Überraschenderweise hat sich gezeigt, dass auch Nanopartikel aus Silber, Gold, Platin, Palladium, Wolfram, Nickel, Zinn, Bismut, Eisen, Indiumzinnoxid, Wolframoxid, Titancarbid oder Titannitrid als Absorptionsmittel für Laserstrahlung eingesetzt werden können. Auf diese Weise ist es möglich, auf elementaren Kohlenstoff, zum Beispiel in Form von Ruß, Kohlenstoffnanoröhrchen, Graphenen oder Graphit, als Absorptionsmittel für Laserstrahlung zu verzichten oder die benötigte Menge deutlich im Vergleich zu bekannten Zusammensetzungen zu reduzieren.

Ein weiterer Vorteil der Verwendung von Silber, Gold, Platin, Palladium, Wolfram, Nickel, Zinn, Eisen, Bismut, Indiumzinnoxid oder Titancarbid ist, dass diese Materialen elektrisch leitfähig sind. Aus diesem Grund wird durch den Einsatz der Nanopartikel die elektrische Leitfähigkeit der gedruckten Leiterbahnen in sehr viel geringerem Maße oder bevorzugt nicht herabgesenkt. Zudem oxidieren diese Materialien beim Brennen nicht, insbesondere ergeben sie keine gasförmigen Verbindungen, die zu einer Porosität der Leiterbahnen und dadurch zu einer Herabsetzung der Leitfähigkeit führen können. Titancarbid als Absorptionsmittel kann verbrennen, die dabei freigesetzte Menge an Kohlenstoff ist jedoch sehr viel geringer als die freigesetzte Menge bei Verwendung von elementarem Kohlenstoff als Absorptionsmittel.

Besonders bevorzugt als Material für die Nanopartikel ist Silber.

In einer Ausführungsform sind die Nanopartikel sphärische Partikel. Sphärische Partikel im Rahmen der vorliegenden Erfindung bedeutet, dass die Partikel im Wesentlichen Kugelform haben, die realen Partikel jedoch auch Abweichungen von der idealen Kugelform aufweisen können. So können die realen Partikel zum Beispiel auch abgeflacht sein oder eine Tropfenform aufweisen. Auch sonstige Abweichungen von der idealen Kugelform, die herstellungsbedingt auftreten können, sind möglich.

Wenn die Nanopartikel sphärische Partikel sind, so weisen diese vorzugsweise einen Durchmesser im Bereich von 2 bis 50 nm auf. Insbesondere bei Verwendung von Infrarot-Lasern, insbesondere solchen mit einer Wellenlänge von 1050 nm hat sich gezeigt, dass sphärische Nanopartikel mit einem Partikeldurchmesser im Bereich von 2 bis 50 nm besonders geeignet sind. Besonders bevorzugt liegt der Durchmesser der sphärischen Partikel im Bereich von 6 nm.

Wenn die Nanopartikel in Form sphärischer Partikel eingesetzt werden, so liegt der Anteil der Nanopartikel in der Zusammensetzung insbesondere im Bereich von 0,5 bis 12 Gew.-%.

In einer alternativen Ausführungsform sind die Nanopartikel Prismen mit einer Kantenlänge im Bereich von 15 bis 1000 nm und einer Höhe von 3 bis 100 nm. Die Form der Prismen ist dabei variabel. So hängt die Form unter anderem auch von der eingesetzten Laserstrahlung ab. Die Grundfläche der Prismen kann so zum Beispiel in Form eines beliebigen Polygons, beispielsweise eines Dreiecks oder eines Fünfecks, ausgebildet sein. Die als Nanopartikel eingesetzten Prismen sind im Allgemeinen Plasmonresonatoren, deren Absorptionsverhalten an die Wellenlänge des eingesetzten Lasers angepasst ist. Die Anpassung an die Wellenlänge des eingesetzten Lasers erfolgt zum Beispiel durch die Kantenlänge der Prismen und durch die Querschnittsfläche. So weisen zum Beispiel unterschiedliche Querschnittsflächen und unterschiedliche Kantenlängen jeweils ein unterschiedliches Absorptionsverhalten auf. Auch übt die Höhe der Prismen einen Einfluss auf das Absorptionsverhalten aus.

Wenn Prismen als Nanopartikel eingesetzt werden, so liegt der Anteil der als Prismen vorliegenden Nanopartikel in der Zusammensetzung vorzugsweise im Bereich von 3 bis 10 Gew.-%.

Neben dem Einsatz von sphärischen Partikeln oder Prismen als Absorptionsmittel für Laserstrahlung ist es alternativ auch möglich, dass sowohl sphärische Partikel als auch Prismen eingesetzt werden. Dabei ist jedes beliebige Verhältnis an sphärischen Partikeln zu Prismen möglich. Je größer der Anteil an Nanopartikeln in Form von Prismen ist, umso niedriger kann der Anteil an Nanopartikeln in der Zusammensetzung sein.

Die Nanopartikel werden im Allgemeinen bei der Herstellung, insbesondere für den Transport, durch geeignete Additive stabilisiert. Bei der Herstellung der Zusammensetzung zum Drucken von Leiterbahnen werden die Additive üblicherweise nicht entfernt, so dass diese dann auch in der Zusammensetzung enthalten sind. Der Anteil an Additiven zur Stabilisierung liegt im Allgemeinen bei maximal 15 Gew.-% bezogen auf die Masse an Nanopartikeln. Als Additive zur Stabilisierung der Nanopartikel können zum Beispiel langkettige Amine, beispielsweise Dodecylamin eingesetzt werden. Weitere Additive, die sich zur Stabilisierung der Nanopartikel eignen, sind zum Beispiel Octylamin, Decylamin, Ölsäure und Polyethylenimine.

In der Zusammensetzung enthaltene, elektrisch leitfähige Partikel können Partikel beliebiger Geometrie aus einem beliebigen elektrisch leitfähigen Material sein. Vorzugsweise enthalten elektrisch leitfähige Partikel, die in der Zusammensetzung enthalten sind, Silber, Gold, Aluminium, Platin, Palladium, Zinn, Nickel, Cadmium, Gallium, Indium, Kupfer, Zink, Eisen, Bismuth, Cobalt, Mangan, Chrom, Vanadium, Titan oder Mischungen oder Legierungen daraus.

Die mittlere Partikelgröße der eingesetzten Partikel liegt vorzugsweise im Bereich von 100 nm bis 100 µm. Mehr bevorzugt liegt die mittlere Partikelgröße im Bereich von 500 nm bis 50 µm und insbesondere im Bereich von 500 nm bis 10 µm. Die eingesetzten Partikel können dabei jede beliebige, dem Fachmann bekannte Form aufweisen. So können die Partikel zum Beispiel plättchenförmig oder kugelförmig sein. Unter "kugelförmig" sind dabei auch Partikel zu verstehen, deren reale Form von der idealen Kugel-form abweicht. So können kugelförmige Partikel zum Beispiel herstellungsbedingt auch eine tropfenförmige Gestalt aufweisen oder abgeflacht sein. Geeignete Partikel, die zur Herstellung der Zusammensetzung eingesetzt werden können, sind dem Fachmann bekannt und im Handel erhältlich. Insbesondere bevorzugt werden sphärische Silberpartikel eingesetzt. Vorteil der sphärischen Partikel ist deren gegenüber plättchenförmigen Partikeln verbessertes rheologisches Verhalten. So weist eine Zusammensetzung, die sphärische Partikel enthält, eine niedrigere Viskosität auf als eine Zusammensetzung mit plättchenförmigen Partikeln. Zudem weist eine Zusammensetzung, die sphärische Partikel enthält, eine starke Viskositätserniedrigung bei Scherung auf. Hierdurch lassen sich auch hohe Füllgrade von bis zu ungefähr 90% realisieren, bei denen die Zusammensetzung weiterhin druckbar verbleibt.

Sollen zwei oder mehr unterschiedliche Sorten elektrisch leitfähiger Partikel eingesetzt werden, so kann dies durch Mischung der Sorten erfolgen. Die Partikel der unterschiedlichen Sorten können sich dabei im Material, in der Form und/oder in der Größe unterscheiden.

Der Anteil an elektrisch leitfähigen Partikeln in der Zusammensetzung liegt im Bereich von 50 bis 90 Gew.-%. Bevorzugt liegt der Anteil im Bereich von 70 bis 87 Gew.-% und insbesondere im Bereich von 75 bis 85 Gew.-%.

Neben der Verwendung von elektrisch leitfähigen Partikeln, die eine Größe im Bereich von 100 nm bis 100 µm aufweisen, ist es auch möglich, als elektrisch leitfähige Partikel Nanopartikel einzusetzen. Wenn als elektrisch leitfähige Partikel Nanopartikel eingesetzt werden, so weisen diese vorzugsweise einen mittleren Durchmesser im Bereich von 1 bis 500 nm auf. Die Nanopartikel können dabei jede beliebige Form aufweisen. So können die Nanopartikel zum Beispiel ebenfalls sphärische Partikel sein oder in Form von Prismen vorliegen. Insbesondere dienen bei Verwendung von Nanopartikeln als elektrisch leitfähige Partikel die Nanopartikel gleichzeitig auch als Absorptionsmittel für die Laserstrahlung.

Um eine druckbare Zusammensetzung zu erhalten, ist es weiterhin erforderlich, dass die Zusammensetzung ein Lösungsmittel enthält. Der Anteil an Lösungsmittel in der Zusammensetzung liegt im Allgemeinen im Bereich von 3 bis 69 Gew.-%. Bevorzugt liegt der Anteil an Lösungsmittel im Bereich von 5 bis 20 Gew.-% und insbesondere im Bereich von 8 bis 15 Gew.-%.

Als Lösungsmittel können zum Beispiel organische Lösungsmittel eingesetzt werden. Geeignete organische Lösungsmittel sind alle dem Fachmann bekannten Lösungsmittel. Bevorzugt sind Terpineol, Texanol, Ethylenglycol, Propylenglycol und Dipropylenglycol.

Neben dem Einsatz von organischen Lösungsmitteln ist es auch möglich, Wasser als Lösungsmitten zu verwenden. Wenn Wasser als Lösungsmittel eingesetzt wird, so liegt der Anteil an Wasser vorzugsweise im Bereich von 3 bis 40 Gew.-%, mehr bevorzugt im Bereich von 5 bis 15 Gew.-% und insbesondere im Bereich von 6 bis 12 Gew.-%.

Da Wasser im Allgemeinen relativ schnell verdunstet, ist bei Verwendung von Wasser als Lösungsmittel die Zugabe eines Retentionsmittels, einem so genannten Verzögerer, notwendig, um die Verdunstung zu verlangsamen. Das Retentionsmittel liegt in der Zusammensetzung mit einem Anteil von 0,5 bis 50 Gew.-%, bevorzugt mit einem Anteil von 5 bis 40 Gew.-% und insbesondere mit einem Anteil im Bereich von 10 bis 30 Gew.-% vor.

Als Retentionsmittel eignen sich polare, Wasser bindende Lösungsmittel. Geeignete polare, Wasser bindende Lösungsmittel sind zum Beispiel Glycerin, Glykole, beispielsweise Ethylenglykol, Propylenglykol, Polyglykole wie Diethylenglykole, Polyethylenglykole (beispielsweise PEG200), Polypropylenglykol, Alkanolamine, beispielsweise Methyldiethanolamin, Ethyldiethanolamin, n-Methylpyrrolidon oder Polyethylenimine, Polyvinylamin oder Polyvinylformamid. Besonders bevorzugt als Retentionsmittel sind Glycerin oder Polyethylenglykole. Dieses weisen eine hohe Oberflächenspannung auf, wodurch ein Verlaufen der Zusammensetzung auf der Oberfläche des zu bedruckenden Substrates verringert wird. Hierdurch sind klarere Strukturen druckbar.

Um bei der Herstellung von Solarzellen eine gute Verbindung von mit der Zusammensetzung gedruckten Elektrodenstrukturen auf dem Halbleitersubstrat zu erhalten, wird das auch als Wafer bezeichnete Halbleitersubstrat mit den darauf aufgedruckten Strukturen gebrannt. Damit die Zusammensetzung vor dem Brennen am Wafer haftet, ist vorzugsweise weiterhin ein Matrixmaterial enthalten. Wenn in der Zusammensetzung ein Matrixmaterial enthalten ist, so liegt der Anteil an Matrixmaterial vorzugsweise im Bereich von 0,1 bis 8 Gew.-%, weiter bevorzugt im Bereich von 0,5 bis 5 Gew.-% und insbesondere im Bereich von 1 bis 3 Gew.-%.

Wenn Wasser als Lösungsmittel verwendet wird, so werden als Matrixmaterial vorzugsweise wasserlösliche oder wasserdispergierbare Polymere oder Polymergemische eingesetzt.

Bevorzugt sind wasserlösliche bzw. wasserdispergierbare Polymere oder Polymergemische, die niedrigviskose Lösungen in Wasser bilden. Hierdurch ist ein hoher Füllgrad an elektrisch leitfähigen Partikeln bei geringer Viskosität möglich. Weiterhin sollten die eingesetzten Polymere eine gute Haftung zur zu bedruckenden Substratoberfläche, beispielsweise bei der Herstellung von Solarzellen der Oberfläche des eingesetzten Solar-Wafers, aufweisen. Auch sollten die Polymere zu einer ausreichenden Integrität der gedruckten Leiterbahnen führen.

Geeignete Polymere, die als Matrixmaterial verwendet werden können, sind zum Beispiel Acrylatdispersionen und Acrylat-Copolymere, beispielsweise Styrol-Acrylate, alkalilösliche Acrylatharze und dessen Copolymere, Maleinsäureanhydridcopolymere, beispielsweise Styrol-Maleinsäuredispersionen, Alkydharzdispersionen, Styrolbutadiendispersionen, Cellulosederivate, insbesondere Hydroxyalkylcellulosen, Carboxyalkylcellulosen, Polyesterdispersionen, Polyvinylalkohole, insbesondere teil- oder vollverseifte Polyvinylalkohole, hydrolisierte Vinylacetatcopolymere, beispielsweise gepfropfte Polyethylenglykol-Vinylacetat-Copolymere, Polyvinylpyrrolidon und Vinylpyrrolidon-Copolymere, Polyethylenimine, Polyvinylamin, Polyvinylformamid, hyperverzweigte Polycarbonate, Polyglykole, Polyurethandispersionen, Proteine, beispielsweise Casein. Auch können Mischungen zweier oder mehrerer Polymere das Matrixmaterial bilden.

Wenn als Lösungsmittel nur organische Lösungsmittel eingesetzt werden, so eignen sich als Matrixmaterial zum Beispiel ABS (Acrylnitril-Butadien-Styrol); ASA (Acrylnitril-Styrol-Acrylat); acrylierte Acrylate; Alkydharze; Alkylvinylacetate; Alkylenvinylacetat-Copolymere, insbesondere Methylenvinylacetat, Ethylenvinylacetat, Butylenvinylacetat; Alkylenvinylchlorid-Copolymere; Aminoharze; Aldehyd- und Ketonharze; Cellulose und Cellulosederivate, insbesondere Hydroxyalkylcellulose, Celluloseester, wie -Acetate, -Propionate, -Butyrate, Carboxyalkylcellulosen, Cellulosenitrat; Epoxyacrylate; Epoxidharze; modifizierte Epoxidharze, zum Beispiel bifunktionelle oder polyfunktionelle Bisphenol A oder Bisphenol F-Harze, polyfunktionelle Epoxy-Novolak-Harze, bromierte Epoxidharze, cycloaliphatische Epoxidharze; aliphatische Epoxidharze, Glycidether, Vinylether, Ethylenacrylsäurecopolymere; Kohlenwasserstoffharze; MABS (transparentes ABS mit Acrylat-Einheiten enthaltend); Melaminharze, Maleinsäureanhydridcopolymerisate; Methacrylate; Naturkautschuk; synthetischer Kautschuk; Chlorkautschuk; Naturharze; Kollophoniumharze; Schellack; Phenolharze; Phenoxyharze, Polyester; Polyesterharze, wie Phenylesterharze; Polysulfone; Polyethersulfone; Polyamide; Polyimide; Polyaniline; Polypyrrole; Polybutylenterephthalat (PBT); Polycarbonat (zum Beispiel Makrolon^{®} der Bayer AG); Polyesteracrylate; Polyetheracrylate; Polyethylen; Polyethylenthiophene; Polyethylennaphthalate; Polyethylenterephthalat (PET); Polyethylenterephthalat-Glykol (PETG); Polypropylen; Polymethylmethacrylat (PMMA); Polyphenylenoxid (PPO); Polystyrole (PS), Polytetrafluorethylen (PTFE); Polytetrahydrofuran; Polyether (zum Beispiel Polyethylenglykol, Polypropylenglykol), Polyvinylverbindungen, insbesondere Polyvinylchlorid (PVC), PVC-Copolymere, PVdC, Polyvinylacetat sowie deren Copolymere, gegebenenfalls teilhydrolysierter Polyvinylalkohol, Polyvinylacetale, Polyvinylacetate, Polyvinylpyrrolidon, Polyvinylether, Polyvinylacrylate und -methacrylate in Lösung und als Dispersion sowie deren Copolymere, Polyacrylsäureester und Polystyrolcopolymere, zum Beispiel Polystyrolmaleinsäureanhydridcopolymere; Polystyrol (schlagfest oder nicht schlagfest modifiziert); Polyurethane, unvernetzte beziehungsweise mit Isocyanaten vernetzt; Polyurethanacrylate; Styrol-AcrylCopolymere; Styrol-Butadien-Blockcopolymere (zum Beispiel Styroflex^{®} oder Styrolux^{®} der BASF AG, K-Resin™ der CPC); Proteine, wie zum Beispiel Casein; Styrol-Isopren-Blockcopolymere; Triazin-Harze, Bismaleimid-Triazin-Harze (BT), Cyanatester-Harz (CE), Allylierter Polyphenylen-äther (APPE). Weiterhin können Mischungen zweier oder mehrerer Polymere das Matrixmaterial bilden.

Um eine gute Anhaftung der Zusammensetzung an das als Substrat eingesetzte Halbleitermaterial bei der Herstellung von Solarzellen zu erhalten, ist in der Zusammensetzung eine Glasfritte mit einem Anteil im Bereich von 0,5 bis 6 Gew.-% enthalten. Bevorzugt liegt der Anteil an Glasfritte im Bereich von 1,5 bis 4 Gew.-% und insbesondere im Bereich von 2 bis 3,5 Gew.-%.

Eingesetzt werden vorzugsweise im Wesentlichen bleifreie Glasfritten. Derartige Glasfritten sind zum Beispiel Bismutoxid-basierte Gläser. Für die Zusammensetzung geeignete Glasfritten enthalten insbesondere Bismutoxid, Siliciumoxid und/oder Telluroxid.

Der Anteil an Telluroxid liegt vorzugsweise im Bereich von 0,01 bis 10 Gew.-%. Der Anteil an Bismutoxid liegt vorzugsweise im Bereich von 40 bis 95 Gew.-%. Mehr bevorzugt liegt der Anteil an Bismutoxid im Bereich von 50 bis 80 Gew.-% und insbesondere im Bereich von 60 bis 75 Gew.-%. Der Anteil an Siliciumoxid liegt vorzugsweise im Bereich von 0 bis 30 Gew.-%, insbesondere im Bereich von 1 bis 4 Gew.-%.

Neben Bismutoxid, Siliciumoxid und Telluroxid kann die Glasfritte zusätzlich Boroxid enthalten. Der Anteil an Boroxid liegt dabei vorzugsweise im Bereich von 0,1 bis 10 Gew.-%, insbesondere im Bereich von 0,5 bis 8 Gew.-% und in einer besonders bevorzugten Ausführungsform im Bereich von 1 bis 4 Gew.-%.

Zusätzlich zu den genannten Oxiden kann die Glasfritte Zinkoxid und/oder Aluminiumoxid enthalten. Der Anteil an Zinkoxid liegt dabei im Bereich von 0 bis 15 Gew.-% und der Anteil an Aluminiumoxid im Bereich von 0 bis 3 Gew.-%.

Weitere Metalloxide, die in der Glasfritte enthalten sein können, sind zum Beispiel Silberoxid (Ag₂O), Antimonoxid (Sb₂O₃), Germaniumoxid (GeO₂), Indiumoxid (In₂O₃), Phosphorpentoxid (P₂O₅), Vanadiumpentoxid (V₂O₅), Niobpentoxid (Nb₂O₅) und Tan-talpentoxid (Ta₂O₅). Der Anteil an Ag₂O, P₂O₅, V₂O₅, Nb₂O₅ und/oder Ta₂O₅, das in der Glasfritte enthalten sein kann, liegt jeweils im Bereich von ungefähr 0 bis 8 Gew.-%. Der Anteil an In₂O₃ und/oder Sb₂O₃ in der Glasfritte liegt vorzugsweise jeweils im Bereich von 0 bis 5 Gew.-%. Zusätzlich können in der Glasfritte ein oder mehrere Alkalioxide, üblicherweise Na₂O, Li₂O und/oder K₂O enthalten sein. Der Anteil an Alkalimetalloxiden in der Glasfritte liegt dabei jeweils im Bereich von 0 bis 3 Gew.-%. Weiterhin können auch Erdalkalimetalloxide in der Glasfritte enthalten sein. Üblicherweise enthaltene Erdalkalioxide sind BaO, CaO, MgO und/oder SrO. Der Anteil an Erdalkalioxiden in der Glasfritte liegt dabei jeweils im Bereich von 0 bis 8 Gew.-%.

Im Wesentlichen bleifrei im Sinne der vorliegenden Erfindung bedeutet, dass der Glasfritte kein Blei zugegeben wird und der Anteil an Blei in der Glasfritte kleiner als 1000 ppm ist.

In einer bevorzugten Ausführungsform ist zumindest ein Teil der Nanopartikel im Glas der Glasfritte eingeschlossen. In diesem Fall ist es bevorzugt, wenn das Material der Nanopartikel Bismut ist. Wenn nur ein Teil der Nanopartikel im Glas der Glasfritte eingeschlossen ist, kann das Material der eingeschlossenen Nanopartikel das Gleiche sein wie das der nicht eingeschlossenen Nanopartikel. Es ist aber auch möglich, Nanopartikel aus unterschiedlichen Materialien einzusetzen, wobei zum Beispiel die im Glas der Glasfritte eingeschlossenen Nanopartikel aus einem anderen Material bestehen als die nicht eingeschlossenen Nanopartikel. Weiterhin können aber auch in dem Glas der Glasfritte bereits Nanopartikel aus unterschiedlichen Materialien eingeschlossen sein.

Die erfindungsgemäße Zusammensetzung enthält weiterhin mindestens eine metallorganische Verbindung. Der Anteil der metallorganischen Verbindung in der Zusammensetzung liegt im Bereich von 0 bis 5 Gew.-%, bevorzugt im Bereich von 1 bis 3 Gew.-% und insbesondere im Bereich von 1,5 bis 2,5 Gew.-%.

Beim Brennen des Substrats mit der darauf aufgedruckten Zusammensetzung wird der organische Bestandteil der metallorganischen Verbindung zersetzt und aus der Zusammensetzung entfernt. Das enthaltene Metall verbleibt in der Zusammensetzung.

Geeignete metallorganische Verbindungen, die eingesetzt werden können, sind Metallcarboxylate, Metallpropionate, Metallalkoxide, Komplexverbindungen eines Metalls oder eine Mischung daraus. Weiterhin können die metallorganischen Verbindungen auch aromatische oder aliphatische Gruppen enthalten.

Geeignete Carboxylate sind zum Beispiel Formiate, Acetate oder Propionate. Als Alkoxide eignen sich zum Beispiel Methanolat, Ethanolat, Propanolat, Butanolat, Pentanolat, Hexanolat, Heptanolat, Octanolat, Nonanolat, Decanolat, Undecanolat und Dodecanolat.

Das Metall der metallorganischen Verbindung ist vorzugsweise ausgewählt aus der Gruppe bestehend aus Aluminium, Bismut, Zink und Vanadium.

Zusätzlich kann die metallorganische Verbindung Bor oder Silicium enthalten.

Geeignete metallorganische Verbindungen, die eingesetzt werden können, sind zum Beispiel Bismut(III)acetat, Triphenylbismut, Bismut(III)hexafluoropentandionat, Bismut(III)tetramethylheptandionat, Bismutneodecanoat, Bismut(III)-2-ethylhexanoat, Bismutcarbonatoxid, Bismutsubgallathydrat, Bismut(III)gallatbasishydrat, Bismut(III)subsalicylat, Bismut(III)tris(2,2,6,6-tetramethyl-3,5-heptandionat), Triphenylbismut(III)carbonat, Tris(2-methoxyphenyl)bismutin.

Insbesondere bevorzugte metallorganische Verbindungen sind Bismut(III)acetat, Bismut(III)2-ethylhexanoat, Bismutcarbonatoxid, Bismutsubgallathydrat, Bismut(III)gallatbasishydrat, Bismut(III)subsalicylat.

Weiterhin kann die Zusammensetzung auch weitere Additive enthalten. Additive, die in der Zusammensetzung enthalten sein können, sind zum Beispiel Dispergiermittel, Thixotropiermittel, Weichmacher, Entschäumer, Trockenstoffe, Vernetzer, Komplexbildner und/oder leitfähige Polymerpartikel. Die Additive können dabei jeweils einzeln oder als Mischung von zwei oder mehreren der Additive eingesetzt werden.

Der Anteil an Additiven in der Zusammensetzung liegt im Allgemeinen im Bereich von 0 bis 5 Gew.-%, bevorzugt im Bereich von 0,1 bis 3 Gew.-% und insbesondere im Bereich von 0,1 bis 2 Gew.-%.

Wenn als Additiv ein Dispergiermittel eingesetzt wird, so ist es möglich, nur ein Dispergiermittel oder mehrere Dispergiermitel zu verwenden.

Grundsätzlich sind alle dem Fachmann für die Anwendung in Dispersionen bekannten und im Stand der Technik beschriebenen Dispergiermittel geeignet. Bevorzugte Dispergiermittel sind Tenside oder Tensidgemische, beispielsweise anionische, kationische, amphotere oder nicht-ionische Tenside. Geeignete kationische und anionische Tenside sind beispielsweise in "Encyclopedia of Polymer Science and Technology", J. Wiley & Sons (1966), Band 5, Seiten 816 bis 818 und in "Emulsion Polymerisation and

Emulsion Polymers", Herausgeber P. Lovell und M. EI-Asser, Verlag Wiley & Sons (1997), Seiten 224 bis 226, beschrieben. Es ist aber auch die Verwendung von dem Fachmann bekannten Polymeren mit pigmentaffinen Ankergruppen als Dispergiermittel möglich.

Wenn Thixotropiermittel als Additiv zugesetzt werden, so können zum Beispiel organische Thixotropiermittel verwendet werden. Verdicker, die eingesetzt werden können, sind zum Beispiel Polyacrylsäure, Polyurethane oder hydriertes Rizinusöl.

Weichmacher, Netzmittel, Entschäumer, Trockenstoffe, Vernetzer, Komplexbildner und leitfähige Polymerpartikel, die eingesetzt werden können, sind solche, wie sie üblicherweise in Dispersionen eingesetzt werden und dem Fachmann bekannt sind.

Die Herstellung der erfindungsgemäßen Zusammensetzung erfolgt zum Beispiel durch intensives Mischen und Dispergieren in dem Fachmann bekannten Aggregaten. Dies beinhaltet zum Beispiel das Vermischen der Komponenten in einem Dissolver oder einem vergleichbar intensiv dispergierenden Aggregat, die Dispergierung in einer Rührwerkskugelmühle oder einem Pulverfluidisator bei Herstellung großer Mengen.

Die erfindungsgemäße Zusammensetzung eignet sich insbesondere zum Aufbringen auf ein Substrat durch ein Laserdruckverfahren.

Insbesondere eignet sich die Zusammensetzung zur Herstellung von Solarzellen.

Hierzu wird die Zusammensetzung auf ein Halbleitersubstrat aufgedruckt, indem die Zusammensetzung von einem Träger durch Einstrahlung mit einem Laser auf das Halbleitersubstrat übertragen wird, wobei Energie des Lasers von den Nanopartikeln absorbiert und in Wärme gewandelt wird, wodurch Lösungsmittel verdampft und ein Tropfen der Zusammensetzung vom Träger auf das Halbleitersubstrat geschleudert wird.

Dieses Verfahren ermöglicht eine präzise Herstellung von Leiterbahnen auf dem Halbleitersubstrat. Bei Herstellung von Solarzellen handelt es sich bei dem Halbleitersubstrat im Allgemeinen um einen Siliciumhalbleiter. Dieser wird auch als Solarwafer bezeichnet.

Der eingesetzte Laser, um die Zusammensetzung auf das Halbleitersubstrat zu drucken, ist vorzugsweise ein Infrarot-Laser. Insbesondere ist der Laser ein Infrarot-Laser mit einer Wellenlänge von 1050 nm. Hierbei ist jeder beliebige Infrarot-Laser, der dem Fachmann bekannt ist, einsetzbar.

## Patentansprüche

1. Zusammensetzung zum Drucken von Leiterbahnen auf ein Substrat, insbesondere für Solarzellen, unter Einsatz eines Laserdruckverfahrens, wobei die Zusammensetzung 30 bis 90 Gew.-% elektrisch leitfähige Partikel mit einer Partikelgröße im Bereich von 100 nm bis 100 µm, 0 bis 7 Gew.-% Glasfritte, 0 bis 8 Gew.-% mindestens eines Matrixmaterials, 0 bis 8 Gew.-% mindestens einer metallorganischen Verbindung, 0 bis 5 Gew.-% mindestens eines Additivs und 3 bis 69 Gew.-% Lösungsmittel enthält, **dadurch gekennzeichnet, dass** die Zusammensetzung weiterhin 0,5 bis 15 Gew.-% Nanopartikel als Absorptionsmittel für Laserstrahlung enthält, wobei die Nanopartikel Partikel aus Silber, Gold, Platin, Palladium, Wolfram, Nickel, Zinn, Bismut, Eisen, Indiumzinnoxid, Titancarbid, Wolframoxid oder Titannitrid sind und die Zusammensetzung maximal 1 Gew.-% elementaren Kohlenstoff enthält und die Nanopartikel sphärische Partikel sind, die einen Durchmesser im Bereich von 2 bis 50 nm aufweisen, oder Prismen mit einer Kantenlänge im Bereich von 15 bis 1000 nm und einer Höhe von 3 bis 100 nm sind.

2. Zusammensetzung gemäß Anspruch 1, **dadurch gekennzeichnet, dass** der Anteil der Nanopartikel in Form sphärischer Partikel im Bereich von 0,5 bis 12 Gew.-% liegt.

3. Zusammensetzung gemäß Anspruch 1, **dadurch gekennzeichnet, dass** die als Nanopartikel eingesetzten Prismen Plasmonresonatoren sind, deren Absorptionsverhalten an die Wellenlänge des eingesetzten Lasers angepasst ist.

4. Zusammensetzung gemäß Anspruch 1 oder 3, **dadurch gekennzeichnet, dass** der Anteil der als Prismen vorliegenden Nanopartikel im Bereich von 3 bis 10 Gew.-% liegt.

5. Zusammensetzung gemäß einem der Ansprüche 1 bis 4, **dadurch gekennzeichnet, dass** die Nanopartikel durch ein langkettiges Amin stabilisiert sind.

6. Zusammensetzung gemäß einem der Ansprüche 1 bis 5, **dadurch gekennzeichnet**, das zumindest ein Teil der Nanopartikel im Glas der Glasfritte eingeschlossen ist.

7. Zusammensetzung gemäß einem der Ansprüche 1 bis 6, **dadurch gekennzeichnet, dass** die elektrisch leitfähigen Partikel Silber, Gold, Aluminium, Platin, Palladium, Zinn, Nickel, Cadmium, Gallium, Indium, Kupfer, Zinn, Eisen, Bismuth, Cobalt, Mangan, Chrom, Vanadium, Titan oder Mischungen oder Legierungen daraus enthalten und vorzugsweise eine mittlere Partikelgröße im Bereich von 100 nm bis 100 µm aufweisen.

8. Zusammensetzung gemäß einem der Ansprüche 1 bis 7, **dadurch gekennzeichnet, dass** als Glasfritte ein Bismuthoxid-basiertes, bleifreies Glas verwendet wird, das vorzugsweise 0,01 bis 10 Gew.-% Telluroxid enthält.

9. Verfahren zur Herstellung von Solarzellen, bei dem eine Zusammensetzung gemäß einem der Ansprüche 1 bis 8 auf ein Halbleitersubstrat aufgedruckt wird, indem die Zusammensetzung von einem Träger durch Einstrahlung mit einem Laser auf das Halbleitersubstrat übertragen wird, wobei Energie des Lasers von den Nanopartikeln absorbiert und in Wärme gewandelt wird, wodurch Lösungsmittel verdampft und ein Tropfen der Zusammensetzung vom Träger auf das Halbleitersubstrat geschleudert wird.

10. Verfahren gemäß Anspruch 9, **dadurch gekennzeichnet, dass** der Laser ein Infrarot-Laser ist.

11. Verfahren gemäß Anspruch 9 oder 10, **dadurch gekennzeichnet, dass** das Halbleitersubstrat ein Siliciumhalbleiter ist.

## Claims

1. A composition for printing conductor tracks onto a substrate, especially for solar cells, using a laser printing process, which composition comprises 30 to 90% by weight of electrically conductive particles having a particle size in the range from 100 nm to 100 µm, 0 to 7% by weight of glass frit, 0 to 8% by weight of at least one matrix material, 0 to 8% by weight of at least one organometallic compound, 0 to 5% by weight of at least one additive and 3 to 69% by weight of solvent, wherein the composition further comprises 0.5 to 15% by weight of nanoparticles as absorbents for laser radiation, which nanoparticles are particles of silver, gold, platinum, palladium, tungsten, nickel, tin, bismuth, iron, indium tin oxide, titanium carbide, tungsten oxide or titanium nitride, and the composition comprises not more than 1% by weight of elemental carbon, and the nanoparticles are spherical particles which have a diameter in the range from 2 to 50 nm, or are prisms with an edge length in the range from 15 to 1000 nm and a height of 3 to 100 nm.

2. The composition according to claim 1, wherein the proportion of the nanoparticles in the form of spherical particles is in the range from 0.5 to 12% by weight.

3. The composition according to claim 1, wherein the prisms used as nanoparticles are plasmon resonators whose absorption behavior is matched to the wavelength of the laser used.

4. The composition according to claim 1 or 3, wherein the proportion of the nanoparticles present as prisms is in the range from 3 to 10% by weight.

5. The composition according to any of claims 1 to 4, wherein the nanoparticles are stabilized by a long-chain amine.

6. The composition according to any of claims 1 to 5, wherein at least some of the nanoparticles are included in the glass of the glass frit.

7. The composition according to any of claims 1 to 6, wherein the electrically conductive particles comprise silver, gold, aluminum, platinum, palladium, nickel, cadmium, gallium, indium, copper, tin, iron, bismuth, cobalt, manganese, chromium, vanadium, titanium or mixtures or alloys thereof, and preferably have a mean particle size in the range from 100 nm to 100 µm.

8. The process according to any of claims 1 to 7, wherein the glass frit used is a bismuth oxide-based, lead-free glass which preferably comprises 0.01 to 10% by weight of tellurium oxide.

9. A process for producing solar cells, in which a composition according to any of claims 1 to 8 is printed onto a semiconductor substrate, by transferring the composition from a carrier by irradiation with a laser onto the semiconductor substrate, energy of the laser being absorbed by the nanoparticles and converted to heat, which evaporates solvent and propels a droplet of the composition from the carrier onto the semiconductor substrate.

10. The process according to claim 9, wherein the laser is an infrared laser.

11. The process according to claim 9 or 10, wherein the semiconductor substrate is a silicon semiconductor.

## Revendications

1. Composition pour l'impression de pistes conductrices sur un substrat, notamment pour cellules solaires, utilisant un procédé d'impression laser, la composition contenant 30 à 90 % en poids de particules électriquement conductrices d'une taille de particule dans la plage allant de 100 nm à 100 µm, 0 à 7 % en poids d'une fritte de verre, 0 à 8 % en poids d'au moins un matériau de matrice, 0 à 8 % en poids d'au moins un composé métallo-organique, 0 à 5 % en poids d'au moins un additif et 3 à 69 % en poids de solvants, **caractérisée en ce que** la composition contient également 0,5 à 15 % en poids de nanoparticules en tant qu'agent d'absorption pour le rayonnement laser, les nanoparticules étant des particules d'argent, d'or, de platine, de palladium, de tungstène, de nickel, d'étain, de bismuth, de fer, d'oxyde d'indium et d'étain, de carbure de titane, d'oxyde de tungstène ou de nitrure de titane, et la composition contenant au plus 1 % en poids de carbone élémentaire et les nanoparticules étant des particules sphériques qui présentent un diamètre dans la plage allant de 2 à 50 nm ou des prismes d'une longueur d'arête dans la plage allant de 15 à 1 000 nm et d'une hauteur de 3 à 100 nm.

2. Composition selon la revendication 1, **caractérisée en ce que** la proportion de nanoparticules sous la forme de particules sphériques se situe dans la plage allant de 0,5 à 12 % en poids.

3. Composition selon la revendication 1, **caractérisée en ce que** les prismes utilisés en tant que nanoparticules sont des résonateurs plasmoniques dont le comportement d'absorption est adapté à la longueur d'onde du laser utilisé.

4. Composition selon la revendication 1 ou 3, **caractérisée en ce que** la proportion des nanoparticules présentes sous la forme de prismes se situe dans la plage allant de 3 à 10 % en poids.

5. Composition selon l'une quelconque des revendications 1 à 4, **caractérisée en ce que** les nanoparticules sont stabilisées par une amine à chaîne longue.

6. Composition selon l'une quelconque des revendications 1 à 5, **caractérisée en ce qu'**au moins une partie des nanoparticules sont incluses dans le verre de la fritte de verre.

7. Composition selon l'une quelconque des revendications 1 à 6, **caractérisée en ce que** les particules électriquement conductrices contiennent de l'argent, de l'or, de l'aluminium, du platine, du palladium, de l'étain, du nickel, du cadmium, du gallium, de l'indium, du cuivre, du fer, du bismuth, du cobalt, du manganèse, du chrome, du vanadium, du titane ou leurs mélanges ou alliages, et présentent de préférence une taille de particule moyenne dans la plage allant de 100 nm à 100 µm.

8. Composition selon l'une quelconque des revendications 1 à 7, **caractérisée en ce qu'**un verre sans plomb à base d'oxyde de bismuth, contenant de préférence 0,01 à 10 % en poids d'oxyde de tellure, est utilisé en tant que fritte de verre.

9. Procédé de fabrication de cellules solaires, selon lequel une composition selon l'une quelconque des revendications 1 à 8 est imprimée sur un substrat semi-conducteur, par transfert de la composition d'un support sur le substrat semi-conducteur par exposition à un laser, l'énergie du laser étant absorbée par les nanoparticules et transformée en chaleur, le solvant s'évaporant et une goutte de la composition étant projetée depuis le support sur le substrat semi-conducteur.

10. Procédé selon la revendication 9, **caractérisé en ce que** le laser est un laser infrarouge.

11. Procédé selon la revendication 9 ou 10, **caractérisé en ce que** le substrat semi-conducteur est un semi-conducteur de silicium.
